# EUROPEAN PATENT SPECIFICATION

(11) **EP 4 381 459 B1**
(45) Date of publication and mention of the grant of the patent: **06.05.2026**
(21) Application number: 22760897.3
(22) Date of filing: 01.08.2022
(51) Int. Cl.: G06T 3/40, H04N 1/40, G02B 1/00

(54) **MULTI-CHANNEL HIGH-RESOLUTION IMAGING DEVICES INCORPORATING METALENSES**
MEHRKANALIGE HOCHAUFLÖSENDE BILDAUFNAHMEVORRICHTUNGEN MIT METALLENSEN
DISPOSITIFS D'IMAGERIE À HAUTE RÉSOLUTION À CANAUX MULTIPLES INCORPORANT DES MÉTALENTILLES

(30) Priority: 02.08.2021 US 202163228330 P
(43) Date of publication of application: 12.06.2024
(73) Proprietor: Nil Technology ApS, 2800 Kongens Lyngby (DK)
(72) Inventor: QUAADE, Ulrich, 2800 Kongens Lyngby (DK); MATTINSON, Fredrik, 2800 Kongens Lyngby (DK); FRANCOIS, Olivier, 2800 Kongens Lyngby (DK); EILERTSEN, James, 2800 Kongens Lyngby (DK); JOHANSEN, Villads Egede, 2800 Kongens Lyngby (DK)
(74) Representative: Fish & Richardson P.C.
(86) International application number: PCT/EP2022/071563
(87) International publication number: WO 2023/012110

(56) References cited:
- US-A1- 2011 080 487
- US-A1- 2016 241 751
- US-A1- 2020 388 642

## Description

### FIELD OF THE DISCLOSURE

The present disclosure relates to multi-channel imaging devices.

### BACKGROUND

Multi-channel imaging devices can acquire images using image sensors. For example, light entering through an aperture at one end of an image device is directed to one or more image sensors, which include pixels that generate signals in response to sensing received light. The imaging devices sometimes are incorporated into handheld or other portable electronic devices such as smartphones. However, space in such portable devices often is at a premium. Thus, reducing the size or dimensions of the imaging device can be important for such applications. US 2011/080487 A1 discloses a imaging device capable of super-resolution processing using diffractive optics for achieving a compact size. US 2020/388642 A1 discloses usage of metalenses for compact imaging devices.

### SUMMARY

The present disclosure describes multi-channel high-resolution imaging devices incorporating metalenses.

In one aspect, for example, the present disclosure describes an apparatus according to claim 1.

The present disclosure also describes a method according to claim 11.

The details of one or more implementations are set forth in the accompanying drawings and the description below. Other aspects, features and advantages will be apparent from the following detailed description, the accompanying drawings, and the claims.

### BRIEF DESCRIPTION OF THE DRAWINGS

FIG. 1 illustrates a first example of an imaging device.
FIG. 2 illustrates a second example of an imaging device.
FIG. 3 illustrates a third example of an imaging device.
FIG. 4 illustrates a fourth example of an imaging device.
FIG. 5 is a flow chart of an example method for operation of the imaging devices of FIGS. 1 through 4.

### DETAILED DESCRIPTION

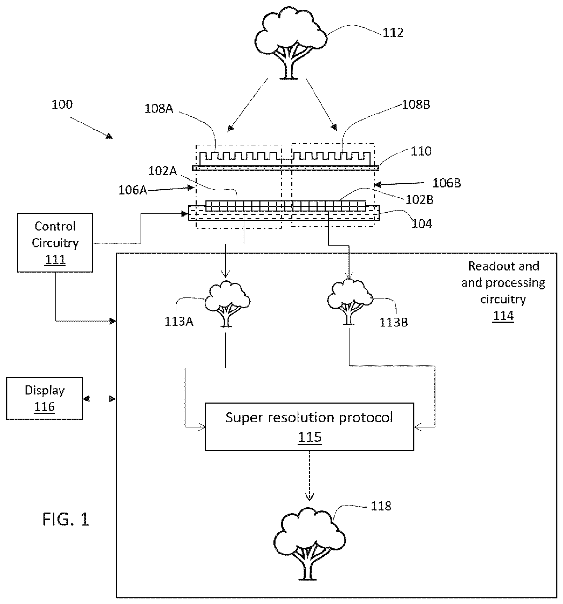

As illustrated in the example of FIG. 1, a multi-channel imaging device 100 is operable to capture images by respective pixel arrays 102A, 102B that are associated with different channels and are part of one or more image sensors. In the illustrated example, a single image sensor 104 is shown and includes both pixel arrays 102A, 102B.

In some implementations, each pixel array 102A, 102B is part of a different respective small image sensor, rather than a single larger image sensor. In any event, each image sensor can be implemented, for example, as a relatively low-cost, low-resolution CCD (charge-coupled device) image sensor or CMOS (complementary metal-oxide-semiconductor) image sensor. That is, although more expensive, high-resolution image sensors can be employed, it is not necessary to do so. Further, although the example of FIG. 1 shows only two optical channels 106A, 106B, some implementations may include a greater number of optical channels.

Each optical channel is configured for detection of incoming light rays of a particular wavelength or a particular range of wavelengths centered on the particular wavelength. For each channel 106A, 106B, a respective metalens is provided to focus incoming light rays onto a respective one of the pixel arrays 102A, 102B. That is, a first metalens 108A, is disposed over the first part of the image sensor 104 that includes the first pixel array 102A, and a second metalens 108B, is disposed over the second part of the image sensor 104 that includes the second pixel array 102B. The first metalens 108A is configured to focus incoming light rays onto the first pixel array 102A, and the second metalens 108B is configured to focus incoming light rays onto the second pixel array 102B. Each metalens 108A, 108B has a metasurface, which refers to a surface with distributed small structures (e.g., meta-atoms) arranged to interact with light in a particular manner. For example, a metasurface, which also may be referred to as a metastructure, can be a surface with a distributed array of nanostructures. The nanostructures are configured to interact, individually or collectively, with light waves so as to change a local amplitude, a local phase, or both, of an incoming light wave.

The meta-atoms (e.g., nanostructures) can be arranged to act as a metalens that resonates at a fixed frequency with a relatively sharp bandwidth. That is, the dimensions (e.g., diameter and length), shape, and material of the meta-atoms can be designed to induce a phase delay in an incident wave of a particular wavelength so as to focus an incident wave on a particular spot. In some implementations, the metalenses 108A, 108B are configured for a particular wavelength or narrow band of wavelengths in the infrared part of the electromagnetic spectrum, whereas in other implementations, the metalenses are configured for a particular wavelength or narrow band of wavelengths in another part of the spectrum (e.g., visible). In any event, each of the metalenses can be configured to focus, onto the respective pixel arrays, incoming light rays of a particular wavelength, or falling within a particular (e.g., narrow) range of wavelengths centered on the particular wavelength.

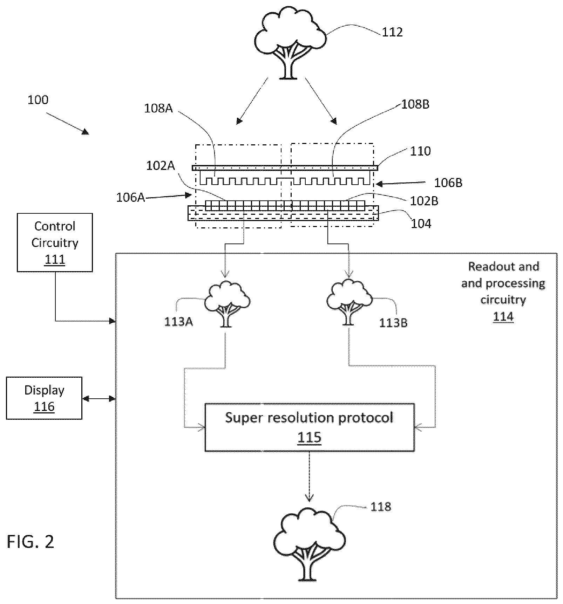

The metalenses 108A, 108B can be supported, for example, by a glass or other substrate 110. Although the example of FIG. 1 shows the metalenses 108A, 108B on the upper surface of the substrate 110, in some case, the metalenses are disposed on the lower surface of the substrate 110, as shown in FIG. 2. In some cases, metalenses may be disposed on both sides of the substrate 110.

In the imaging device 100, each of the optical channels 106A, 106B is configured to acquire monochromatic images of substantially the same color. That is, both channels are configured to detect optical signals having a particular wavelength or falling within the same relatively narrow wavelength range. In particular, the first pixel array 102A can capture an image based on light rays passing through the first optical channel 106A, and the second pixel array 102B can capture an image based on light rays passing through the second optical channel 106B. Further, each pixel array 102A, 102B is operable to acquire an image of a scene from a viewpoint that differs slightly from that of the other pixel array. That is, the image of the scene acquired by a particular one of the pixel arrays differs somewhat from images of the same scene acquired by the other pixel array. The slight difference in viewpoints results in a small shift (i.e., sometimes referred to as "motion") in the images of the scene acquired by the pixel arrays 102A, 102B. The size of the shift may be, for example, sub-pixel.

On the one hand, introducing metalenses into an imaging device as described here is counterintuitive because metalenses are generally known to exhibit relatively large chromatic aberrations, and because they typically generate relatively small images, which makes it difficult in some cases to use the entire active area of a standard image sensor. Nevertheless, by associating each metalens with an optical channel that encompasses only a portion of the total pixels of the image sensor(s), and configuring each of the optical channels 106A, 106B in the imaging device 100 for a single wavelength or a relatively narrow band of wavelengths, the imaging device 100 can take advantage of benefits that metalenses can offer. In particular, using metalenses 108A, 108B rather than other types of lenses (e.g., refractive lenses) in the imaging device 100 can be advantageous because the metalenses can be relatively flat, ultrathin, lightweight, and compact. Thus, using metalenses can help reduce the total track length (TTL) or z-height of the imaging device 100. Further, as explained below, the metalenses can be used in conjunction with one or more relatively low-cost, low-resolution image sensors 104 in a manner that allows for high-resolution images to be obtained.

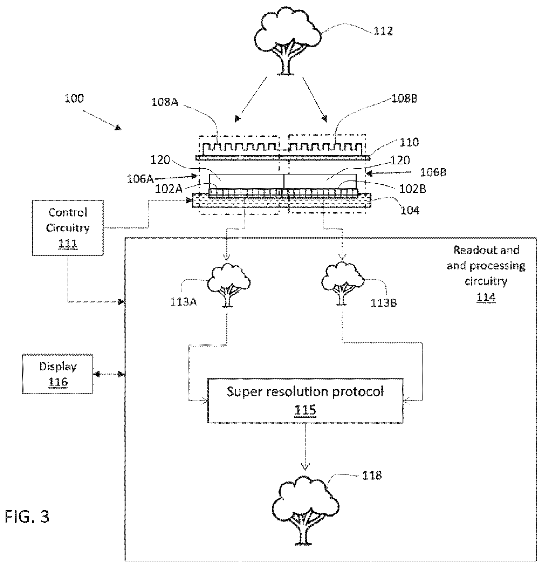

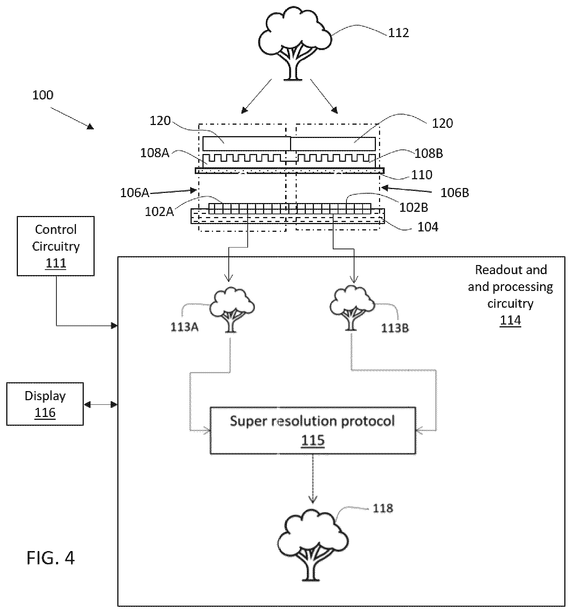

In some cases, it can be beneficial to include an optical filter in each of the channels 106A, 106B. The filters can help eliminate or reduce optical noise that may be present. For example, if the channels 106A, 106B are designed to detect infrared radiation, an infrared filter 120 can be included in each channel, as shown in FIG. 3. In other implementations, optical filters can be included in the optical channels to pass only radiation in a particular part of the visible portion of the spectrum (e.g., red, green or blue). FIG. 3 shows filters 120 as being disposed on the image sensor 104, that is, between the image sensor 104 and the metalenses 108A, 108B. In some implementations, the filters 120 can be disposed over the metalenses 108A, 108B, as shown in FIG. 4.

The imaging device 100 can include control circuitry 111 (e.g., logic) operable to control the image sensor(s) 104 to acquire images of a scene 112 containing one or more objects. In some implementations, the control circuitry 111 may be responsive to user input (e.g., a user interacting with, or otherwise providing input to, a user interface of a smart phone of other computing device coupled to the control circuitry).

The imaging device 100 also can include readout and processing circuitry 114, which can include, for example, a microprocessor and one or more associated memories storing instructions for execution by the microprocessor. The control circuitry 111 can be coupled to the readout and processing circuitry 114 to provide, for example, timing and control signals for reading out the pixel signals. Thus, signals from the pixel arrays 102A, 102B in the various channels 106A, 106B of the imaging device 100 can be read out by the readout and processing circuitry 114, which can include, for example, one or more integrated circuits in one or more semiconductor chips with appropriate digital logic and/or other hardware components (e.g., readout registers; amplifiers; analog-to-digital converters; clock drivers; timing logic; and/or signal processing circuitry).

Depending on the implementation, the readout circuitry can include, for example, active MOS readout amplifiers per pixel. In some implementations, the readout circuitry is operable for intra-pixel charge transfer along with an in-pixel amplifier to achieve correlated double sampling (CDS). The readout circuit can include, in some instances, a source follower or a charge amplifier with row- and column-selection. In some cases, the readout circuit includes a digital readout integrated circuit (DROIC) or a digital pixel readout integrated circuit (DPROIC). In some instances, the pixels are demodulation pixels. Other pixel readout circuits can be used in some implementations.

The readout and processing circuitry 114 is operable to process the pixel signals and to generate, for example, a small, low-resolution image 113A, 113B for each channel 106A, 106B. Thus, the readout and processing circuitry 114 is operable to read out signals from each of the pixels in the pixel arrays 102A, 102B, where the signals from pixels in a particular one of the pixel arrays correspond to a relatively small, low-resolution image of the scene 112.

The readout and processing circuitry 114 also is operable to process the low-resolution images to obtain a higher-resolution monochromatic image 118 using, for example, a super-resolution protocol 115. Super-resolution reconstruction refers to a process of combining information from multiple low-resolution images with sub-pixel displacements to obtain a higher resolution image. The super-resolution reconstruction can include, for example, interpolation-based methods, reconstruction-based methods, or leaming-based methods. In some instances, a standard super-resolution protocol can be used, such as an example-based technique, a sparse-coding-based technique, a projection onto convex sets (POCS) technique, or a Bayesian technique. Some implementations use a fusion super-resolution technique, in which high-resolution images are constructed from low-resolution images, thereby increasing the high-frequency components and removing the degradations caused by the recording process of low-resolution imaging acquisition. In some instances, the super-resolution protocol employs convolutional neural networks. Other super-resolution techniques can be used as well.

The super-resolution reconstructed monochromatic image generated by the readout and processing circuitry 114 can be provided, for example, to a display 116, which displays the super-resolution reconstructed image. The display 116 can include, for example, a screen of a computing device (e.g., a smartphone, tablet, personal computer, or other small computing device).

The imaging device 100 can be used in any of a wide range of applications including, for example, cameras in smartphones and other handheld or portable computing devices, as well as medical imaging, satellite imaging, surveillance, facial recognition, high definition television, and others. In some instances, at least a portion of the readout and processing circuitry 114 for the imaging device 100 may be integrated into the smartphone or other computing device's own processing circuitry. In other instances, the readout and processing circuitry 114 may be separate from such circuitry in the computing device.

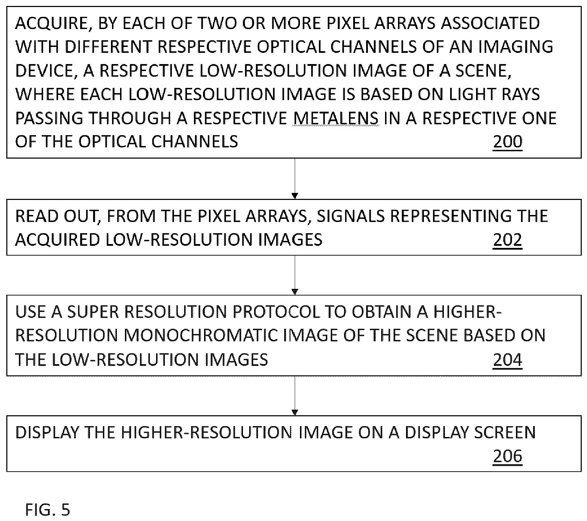

FIG. 5 illustrates an example of a method of using the imaging devices 100 of FIGS. 1, 2, 3 or 4. As indicated by 200, each of two or more pixel arrays associated with different respective optical channels of the imaging device acquires a respective low-resolution image of a scene that includes one or more objects. Each low-resolution image is based (at least in part) on light rays passing through a respective metalens in a respective one of the optical channels. The low-resolution images for the optical channels are substantially monochromatic and are based on light of the same wavelength or the same narrow range of wavelengths. In some instances, the low-resolution images are acquired in response to user input (e.g., input provided by the user through an interactive user interface). As indicated by 202, signals representing the acquired low-resolution images are read out from the pixel arrays. Then, as indicated by 204, the method includes using a super resolution protocol to obtain a higher-resolution monochromatic image of the scene based on the low-resolution images. In some instances, the higher-resolution image is displayed, for example, on a display screen of a smartphone or other computing device, as indicated by 206.

Various aspects of the subject matter and the functional operations described in this specification can be implemented in digital electronic circuitry, or in computer software, firmware, or hardware, including the structures disclosed in this specification and their structural equivalents, or in combinations of one or more of them. Thus, aspects of the subject matter described in this specification can be implemented as one or more computer program products, i.e., one or more modules of computer program instructions encoded on a computer readable medium for execution by, or to control the operation of, data processing apparatus. The computer readable medium can be a machine-readable storage device, a machine-readable storage substrate, a memory device, a composition of matter effecting a machine-readable propagated signal, or a combination of one or more of them. The apparatus can include, in addition to hardware, code that creates an execution environment for the computer program in question, e.g., code that constitutes processor firmware.

A computer program (also known as a program, software, software application, script, or code) can be written in any form of programming language, including compiled or interpreted languages, and it can be deployed in any form, including as a stand-alone program or as a module, component, subroutine, or other unit suitable for use in a computing environment. A computer program does not necessarily correspond to a file in a file system. A program can be stored in a portion of a file that holds other programs or data (e.g., one or more scripts stored in a markup language document), in a single file dedicated to the program in question, or in multiple coordinated files (e.g., files that store one or more modules, sub programs, or portions of code). A computer program, which may be stored as instructions in one or more memories, can be deployed to be executed on one computer or on multiple interconnected computers.

The processes and logic flows described in this specification can be performed by one or more programmable processors executing one or more computer programs to perform functions by operating on input data and generating output. The processes and logic flows can also be performed by, and apparatus can also be implemented as, special purpose logic circuitry, e.g., an FPGA (field programmable gate array) or an ASIC (application specific integrated circuit).

Processors suitable for the execution of a computer program include, by way of example, both general and special purpose microprocessors, and any one or more processors of any kind of digital computer. Generally, a processor will receive instructions and data from a read only memory or a random access memory or both. The essential elements of a computer are a processor for performing instructions and one or more memory devices for storing instructions and data. Computer readable media suitable for storing computer program instructions and data include all forms of non-volatile memory, media and memory devices, including by way of example semiconductor memory devices, e.g., EPROM, EEPROM, and flash memory devices; magnetic disks, e.g., internal hard disks or removable disks; magneto optical disks; and CD ROM and DVD-ROM disks. The processor and the memory can be supplemented by, or incorporated in, special purpose logic circuitry.

Various modifications will be readily apparent from the foregoing detailed description and the drawings. Accordingly, other implementations also are within the scope of the claims.

## Claims

1. An apparatus (100) comprising:
at least one image sensor (104) including a plurality of pixel arrays (102A, 102B), each of the pixel arrays being operable to acquire an image of a scene from a viewpoint that differs slightly from that of any other pixel array of the plurality of pixel arrays, each of the pixel arrays being part of a different one of a plurality of optical channels (106A, 106B), each of the optical channels configured for detection of incoming light rays of substantially a same particular wavelength or substantially a same particular range of wavelengths centered on substantially the same particular wavelength;
a plurality of metalenses (108A, 108B), each of which is disposed, respectively, in a different one of the plurality of optical channels (106A, 106B) and is configured, respectively, to focus incoming light rays onto a different one of the pixel arrays; and
readout and processing circuitry (114) operable to read out signals from the plurality of pixel arrays and to generate a respective lower-resolution monochromatic image for each of the optical channels corresponding to substantially the same particular wavelength or substantially the same particular range of wavelengths centered on substantially the same particular wavelength, and to process the lower-resolution monochromatic images to obtain a higher-resolution monochromatic image.

2. The apparatus of claim 1 wherein each of the plurality of metalenses is configured to focus incoming light rays of the substantially same particular wavelength, or falling within the substantially same particular range of wavelengths, onto a respective one of the pixel arrays.

3. The apparatus of claim 1 wherein each of the plurality of optical channels includes a respective optical filter.

4. The apparatus of claim 3 wherein each optical filter is configured to pass light having the substantially same particular wavelength or falling within the substantially same particular range of wavelengths.

5. The apparatus of any one of claims 3 or 4 wherein each of the optical filters is disposed between the image sensor and a different respective one of the metalenses.

6. The apparatus of any one of claims 3 or 4 wherein each of the optical filters is disposed over a different respective one of the metalenses.

7. The apparatus of any one of claims 1-6 wherein each of the pixel arrays is operable to acquire an image of a scene, and wherein there is a sub-pixel shift in the image acquired by a first one of the pixel arrays relative to the image acquired by a second one of the pixel arrays.

8. The apparatus of any one of claims 1-7 wherein the at least one image sensor includes a plurality of image sensors, each of which includes a different respective one of the pixel arrays.

9. The apparatus of any one of claims 1-7 wherein the at least one image sensor is a single image sensor that includes each of the pixel arrays.

10. The apparatus of any one of claims 1-9 wherein the readout and processing circuitry is operable to process the lower-resolution images to obtain a higher-resolution monochromatic image using a super-resolution protocol.

11. A method comprising:
acquiring (200), by each of two or more pixel arrays being part of different respective optical channels of an imaging device, each of the pixel arrays being operable to acquire an image of a scene from a viewpoint that differs slightly from that of any other pixel array of the two or more pixel arrays, a respective lower-resolution monochromatic image of a scene, where each of the lower-resolution images is based on light rays passing through a respective metalens in a respective one of the optical channels, wherein each of the optical channels is configured for detection of light rays of substantially a same particular wavelength or substantially a same particular range of wavelengths centered on substantially the same particular wavelength;
reading out (202), from the pixel arrays, signals representing the acquired lower-resolution images; and
using (204) a super-resolution protocol to obtain a higher-resolution monochromatic image of the scene based on the lower-resolution monochromatic images.

12. The method of claim 11 including displaying the higher-resolution image on a display screen of a computing device.

13. The method of claim 11 including displaying the higher-resolution image on a display screen of a smartphone.

14. The method of any one of claims 11-13 wherein each respective one of the plurality of metalenses focuses incoming light rays of the substantially same particular wavelength, or falling within the substantially same particular range of wavelengths centered on the particular wavelength, onto the respective one of the pixel arrays, optionally wherein each of the metalenses comprises meta-atoms arranged to resonate at a fixed frequency corresponding to the substantially same particular wavelength.

15. The method of any one of claims 11-14 wherein there is a sub-pixel shift in the lower-resolution image acquired by a first one of the pixel arrays relative to the lower-resolution image acquired by a second one of the pixel arrays.

## Patentansprüche

1. Vorrichtung (100), umfassend:
mindestens einen Bildsensor (104), der eine Vielzahl von Pixelanordnungen (102A, 102B) beinhaltet, wobei jede der Pixelanordnungen dazu betriebsfähig ist, ein Bild einer Szene aus einem Blickwinkel zu erfassen, der sich geringfügig von dem jeder anderen Pixelanordnung der Vielzahl von Pixelanordnungen unterscheidet, wobei jede der Pixelanordnungen Teil eines anderen einer Vielzahl von optischen Kanälen (106A, 106B) ist, wobei jeder der optischen Kanäle zur Erfassung von einfallenden Lichtstrahlen mit im Wesentlichen derselben bestimmten Wellenlänge oder im Wesentlichen demselben bestimmten Wellenlängenbereich, der auf im Wesentlichen derselben bestimmten Wellenlänge zentriert ist, konfiguriert ist;
eine Vielzahl von Metalinsen (108A, 108B), von denen jede jeweils in einem anderen der Vielzahl von optischen Kanälen (106A, 106B) angeordnet ist und jeweils dazu konfiguriert ist, einfallende Lichtstrahlen auf eine andere der Pixelanordnungen zu fokussieren; und
eine Auslese- und Verarbeitungsschaltung (114), die dazu betriebsfähig ist, Signale aus der Vielzahl von Pixelanordnungen auszulesen und für jeden der optischen Kanäle, die im Wesentlichen derselben bestimmten Wellenlänge oder im Wesentlichen demselben bestimmten Wellenlängenbereich entsprechen, der im Wesentlichen auf derselben bestimmten Wellenlänge zentriert ist, ein entsprechendes monochromatisches Bild mit niedrigerer Auflösung zu erzeugen und die monochromatischen Bilder mit niedrigerer Auflösung zu verarbeiten, um ein monochromatisches Bild mit höherer Auflösung zu erlangen.

2. Vorrichtung nach Anspruch 1, wobei jede der mehreren Metalinsen dazu konfiguriert ist, einfallende Lichtstrahlen mit im Wesentlichen derselben bestimmten Wellenlänge oder innerhalb im Wesentlichen desselben bestimmten Wellenlängenbereichs auf eine jeweilige der Pixelanordnungen zu fokussieren.

3. Vorrichtung nach Anspruch 1, wobei jeder der Vielzahl von optischen Kanälen einen jeweiligen optischen Filter umfasst.

4. Vorrichtung nach Anspruch 3, wobei jeder optische Filter dazu konfiguriert ist, Licht mit im Wesentlichen derselben bestimmten Wellenlänge oder innerhalb im Wesentlichen desselben bestimmten Wellenlängenbereichs durchzulassen.

5. Vorrichtung nach einem der Ansprüche 3 oder 4, wobei jeder der optischen Filter zwischen dem Bildsensor und einer jeweils anderen der Metalinsen angeordnet ist.

6. Vorrichtung nach einem der Ansprüche 3 oder 4, wobei jeder der optischen Filter über einer jeweils anderen der Metalinsen angeordnet ist.

7. Vorrichtung nach einem der Ansprüche 1 bis 6, wobei jede der Pixelanordnungen dazu betriebsfähig ist, ein Bild einer Szene zu erfassen, und wobei in dem von einer ersten der Pixelanordnungen erfassten Bild eine Subpixelverschiebung gegenüber dem von einer zweiten der Pixelanordnungen erfassten Bild vorliegt.

8. Vorrichtung nach einem der Ansprüche 1 bis 7, wobei der mindestens eine Bildsensor eine Vielzahl von Bildsensoren umfasst, von denen jeder eine jeweils andere der Pixelanordnungen beinhaltet.

9. Vorrichtung nach einem der Ansprüche 1 bis 7, wobei der mindestens eine Bildsensor ein einzelner Bildsensor ist, der jede der Pixelanordnungen beinhaltet.

10. Vorrichtung nach einem der Ansprüche 1 bis 9, wobei die Auslese- und Verarbeitungsschaltung dazu betriebsfähig ist, die Bilder mit niedrigerer Auflösung zu verarbeiten, um unter Verwendung eines Superauflösungsprotokolls ein monochromes Bild mit höherer Auflösung zu erlangen.

11. Verfahren, umfassend:
Erfassen (200) eines jeweiligen monochromatischen Bildes einer Szene mit niedrigerer Auflösung durch jedes von zwei oder mehreren Pixelanordnungen, die Teil verschiedener optischer Kanäle einer Bildgebungsvorrichtung sind, wobei jede der Pixelanordnungen dazu betriebsfähig ist, ein Bild einer Szene aus einem Blickwinkel zu erfassen, der sich geringfügig von dem jeder anderen Pixelanordnung der zwei oder mehreren Pixelanordnungen unterscheidet, wobei jedes der Bilder mit niedrigerer Auflösung auf Lichtstrahlen basiert, die durch eine jeweilige Metalinse in einem jeweiligen der optischen Kanäle hindurchtreten, wobei jeder der optischen Kanäle zur Erfassung von Lichtstrahlen mit im Wesentlichen derselben bestimmten Wellenlänge oder im Wesentlichen demselben bestimmten Wellenlängenbereich, der im Wesentlichen auf derselben bestimmten Wellenlänge zentriert ist, konfiguriert ist;
Auslesen (202) von Signalen aus den Pixelanordnungen, die die erfassten Bilder mit niedrigerer Auflösung darstellen; und
Verwenden (204) eines Superauflösungsprotokolls, um ein monochromatisches Bild der Szene mit höherer Auflösung auf Grundlage der monochromatischen Bilder mit niedrigerer Auflösung zu erlangen.

12. Verfahren nach Anspruch 11, einschließlich Anzeigen des Bildes mit höherer Auflösung auf einem Bildschirm einer Rechenvorrichtung.

13. Verfahren nach Anspruch 11, einschließlich Anzeigen des Bildes mit höherer Auflösung auf einem Bildschirm eines Smartphones.

14. Verfahren nach einem der Ansprüche 11 bis 13, wobei jede der Vielzahl von Metalinsen einfallende Lichtstrahlen mit im Wesentlichen derselben bestimmten Wellenlänge oder innerhalb desselben bestimmten Wellenlängenbereichs, der auf die bestimmte Wellenlänge zentriert ist, auf die jeweilige Pixelanordnung fokussiert, wobei optional jede der Metalinsen Meta-Atome umfasst, die so angeordnet sind, dass sie bei einer festen Frequenz, die im Wesentlichen derselben bestimmten Wellenlänge entspricht, in Resonanz schwingen.

15. Verfahren nach einem der Ansprüche 11 bis 14, wobei eine Subpixelverschiebung in dem von einer ersten der Pixelanordnungen erfassten Bild mit niedrigerer Auflösung relativ zu dem von einer zweiten der Pixelanordnungen erfassten Bild mit niedrigerer Auflösung vorliegt.

## Revendications

1. Appareil (100), comprenant :
au moins un capteur d'image (104) comprenant une pluralité de réseaux de pixels (102A, 102B), chacun des réseaux de pixels étant exploitable pour acquérir une image d'une scène à partir d'un point de vue qui diffère légèrement de celui de tout autre réseau de pixels de la pluralité de réseaux de pixels, chacun des réseaux de pixels faisant partie d'un canal optique différent parmi une pluralité de canaux optiques (106A, 106B), chacun des canaux optiques étant configuré pour la détection de rayons lumineux entrants ayant sensiblement la même longueur d'onde particulière, ou sensiblement la même gamme particulière de longueurs d'onde centrées sur sensiblement la même longueur d'onde particulière ;
une pluralité de méta-lentilles (108A, 108B), dont chacune est disposée, respectivement, dans un canal optique différent parmi la pluralité de canaux optiques (106A, 106B), et est configurée, respectivement, pour focaliser les rayons lumineux entrants sur un réseau de pixels différent parmi les réseaux de pixels ; et
un ensemble de circuits de lecture et de traitement (114) exploitable pour lire les signaux provenant de la pluralité de réseaux de pixels et pour générer une image monochromatique à plus faible résolution respective pour chacun des canaux optiques correspondant à sensiblement la même longueur d'onde particulière ou à sensiblement la même gamme particulière de longueurs d'onde centrées sur sensiblement la même longueur d'onde particulière, et pour traiter les images monochromatiques à plus faible résolution afin d'obtenir une image monochromatique à plus haute résolution.

2. Appareil de la revendication 1, dans lequel chacune de la pluralité de méta-lentilles est configurée pour focaliser les rayons lumineux entrants ayant sensiblement la même longueur d'onde particulière, ou se situant dans sensiblement la même gamme particulière de longueurs d'onde, sur un réseau de pixels respectif parmi les réseaux de pixels.

3. Appareil de la revendication 1, dans lequel chacun de la pluralité de canaux optiques comprend un filtre optique respectif.

4. Appareil de la revendication 3, dans lequel chaque filtre optique est configuré pour laisser passer la lumière ayant sensiblement la même longueur d'onde particulière ou se situant dans sensiblement la même gamme particulière de longueurs d'onde.

5. Appareil de l'une quelconque des revendications 3 ou 4, dans lequel chacun des filtres optiques est disposé entre le capteur d'image et une méta-lentille respective différente parmi les méta-lentilles.

6. Appareil de l'une quelconque des revendications 3 ou 4, dans lequel chacun des filtres optiques est disposé au-dessus d'une méta-lentille respective différente parmi les méta-lentilles.

7. Appareil de l'une quelconque des revendications 1 à 6, dans lequel chacun des réseaux de pixels est exploitable pour acquérir une image d'une scène, et dans lequel il existe un décalage de sous-pixel dans l'image acquise par un premier des réseaux de pixels par rapport à l'image acquise par un deuxième des réseaux de pixels.

8. Appareil de l'une quelconque des revendications 1 à 7, dans lequel l'au moins un capteur d'image comprend une pluralité de capteurs d'image, dont chacun comprend un réseau de pixels respectif différent parmi les réseaux de pixels.

9. Appareil de l'une quelconque des revendications 1 à 7, dans lequel l'au moins un capteur d'image est un capteur d'image unique qui comprend chacun des réseaux de pixels.

10. Appareil de l'une quelconque des revendications 1 à 9, dans lequel l'ensemble de circuits de lecture et de traitement est exploitable pour traiter les images à plus faible résolution afin d'obtenir une image monochromatique à plus haute résolution à l'aide d'un protocole de super-résolution.

11. Procédé, comprenant :
l'acquisition (200), par chacun parmi deux réseaux de pixels ou plus faisant partie de différents canaux optiques respectifs d'un dispositif d'imagerie, chacun des réseaux de pixels étant exploitable pour acquérir une image d'une scène à partir d'un point de vue qui diffère légèrement de celui de tout autre réseau de pixels parmi les deux réseaux de pixels ou plus, une image monochromatique à plus faible résolution respective d'une scène, où chacune des images à plus faible résolution est basée sur des rayons lumineux passant à travers une méta-lentille respective dans un canal optique respectif parmi les canaux optiques, dans lequel chacun des canaux optiques est configuré pour la détection de rayons lumineux ayant sensiblement une même longueur d'onde particulière, ou sensiblement une même gamme particulière de longueurs d'onde centrées sur sensiblement la même longueur d'onde particulière ;
la lecture (202), à partir des réseaux de pixels, des signaux représentant les images à plus faible résolution acquises ; et
l'utilisation (204) d'un protocole de super-résolution afin d'obtenir une image monochromatique à plus haute résolution de la scène sur la base des images monochromatiques à plus faible résolution.

12. Procédé de la revendication 11, comprenant l'affichage de l'image à plus haute résolution sur un écran d'affichage d'un dispositif informatique.

13. Procédé de la revendication 11, comprenant l'affichage de l'image à plus haute résolution sur un écran d'affichage d'un téléphone intelligent.

14. Procédé de l'une quelconque des revendications 11 à 13, dans lequel chaque méta-lentille respective de la pluralité de méta-lentilles focalise les rayons lumineux entrants ayant sensiblement la même longueur d'onde particulière, ou se situant dans sensiblement la même gamme particulière de longueurs d'onde centrées sur la longueur d'onde particulière, sur le réseau de pixels respectif parmi les réseaux de pixels, dans lequel, éventuellement, chacune des méta-lentilles comprend des méta-atomes agencés pour résonner à une fréquence fixe correspondant à sensiblement la même longueur d'onde particulière.

15. Procédé de l'une quelconque des revendications 11 à 14, dans lequel il existe un décalage de sous-pixel dans l'image à plus faible résolution acquise par un premier des réseaux de pixels par rapport à l'image à plus faible résolution acquise par un deuxième des réseaux de pixels.
